(19) Europäisches Patentamt
European Patent Office
Office européen des brevets

(11) **EP 4 723 475 A1**

(12) **EUROPEAN PATENT APPLICATION**

(43) Date of publication:
08.04.2026 Bulletin 2026/15

(21) Application number: 25204516.6

(22) Date of filing: 25.09.2025

(51) International Patent Classification (IPC):
*H03F 1/32* (2006.01)        *H03F 3/189* (2006.01)
*H03F 3/24* (2006.01)

(52) Cooperative Patent Classification (CPC):
**H03F 3/24; H03F 1/3247; H03F 3/189;**
H03F 2200/451; H03F 2201/3227

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **02.10.2024 FI 20246181**

(71) Applicant: **Nokia Solutions and Networks Oy
02610 Espoo (FI)**

(72) Inventor: **FISCHER-BUHNER, Arne
Leuven (BE)**

(74) Representative: **Nokia EPO representatives
Nokia Technologies Oy
Karakaari 7
02610 Espoo (FI)**

(54) **A PRE-DISTORTER FOR COMPENSATING POWER AMPLIFIER NON-LINEARITIES**

(57) According to an aspect, an apparatus may comprise a digital pre-distorter, DPD, circuitry including at least one first-order infinite impulse response, IIR, filter and at least one second-order IIR filter. The apparatus may further comprise a power amplifier, at least one processor and at least one memory comprising instructions which, when executed by the at least one processor, cause the apparatus at least to compensate for non-linearities in the power amplifier by using the at least one first-order IIR filter and the at least one second-order IIR filter.

FIG. 1

EP 4 723 475 A1

**Description**

**TECHNICAL FIELD**

The disclosure relates generally to wireless communications and, more particularly but not exclusively, to a pre-distorter comprising a plurality of filters and a machine-learning technique to determine coefficients of the plurality of filters.

**BACKGROUND**

New radio has introduced changes to wireless radio access networks. Particularly, new frequency bands, a more flexible nu-merology and resource allocation were introduced to increase spectrum utilization and support a broad range of use cases. Among these cases, Time-Division Duplexing (TDD) has emerged for unpaired frequency bands above 3 GHz, with a flexible assignment of time resources for uplink (UL) and downlink (DL). Rapid alternation between UL and DL may introduce challenges in efficient design of a radio base station front-end. To save power, a transmit processing in a digital front-end (DFE) can temporarily be powered down during UL operation. For the analog side, especially the radio frequency (RF) power amplifier (PA), interruption of a transmission may result in an unwanted transient gain response when resuming operation. In particular, Gallium Nitride (GaN) PA's used in new radio applications often experience such transient behavior. This transient behavior may introduce considerable distortion to the earlier symbols transmitted. Dynamic allocation in new radio TDD will excite these PA transient effect more frequently and there may be a need for a solution to mitigate such effects.

Furthermore, changes in environment, such as thermal effects, where a device comprising such PA's is operating, can affect the gain and linearity properties of PA's, therefore continuous adaptation techniques where performance parameters of radio-front end (e.g., PA gain etc.) are being monitored and changes in compensation techniques may be applied during operation can improve performance.

**SUMMARY**

The scope of protection sought for various example embodiments of the invention is set out by the independent claims. The example embodiments and features, if any, described in this specification that do not fall under the scope of the independent claims are to be interpreted as examples useful for understanding various example embodiments of the invention.

According to a first aspect, an apparatus is disclosed, the apparatus may comprise: a digital pre-distorter, DPD, circuity, comprising a plurality of filters including at least one first-order infinite impulse response, IIR, filter and at least one second-order IIR filter; a power amplifier; at least one processor; and at least one memory comprising instructions which, when executed by the at least one processor, cause the apparatus at least to compensate for non-linearities in the power amplifier by using the at least one first-order IIR filter and the at least one second-order IIR filter.

In an example embodiment of the first aspect, the DPD circuitry is applied in a machine-learning model to obtain coefficients of the plurality of filters.

In an example embodiment of the first aspect, the machine-learning model comprises a backpropagation through time, BPTT, training technique.

In an example embodiment of the first aspect, initiating coefficients of the plurality of filters comprises a noise value.

In an example embodiment of the first aspect, the DPD circuitry operates at a lower sample rate, than an operation sample rate of a baseband processing system operated by the apparatus.

An example embodiment of the first aspect may further comprise a short-term digital pre-distorter, ST-DPD, circuitry comprising an input and an output; the DPD circuity further comprises an input and an output; and wherein the instructions, when executed by the at least one processor, further cause the apparatus at least to: compensate for short-term non-linearities in the power amplifier by using the ST-DPD circuitry.

In an example embodiment of the first aspect, the instructions, when executed by the at least one processor, further cause the apparatus at least to: determine an intermediate result based an input signal and a reciprocal of an output signal provided by the output of the DPD circuitry; and provide the intermediate result to the input of the ST-DPD circuitry; and obtain a combined output signal from the output of the ST-DPD circuitry based at least partially on the intermediate result.

In an example embodiment of the first aspect, the instructions, when executed by the at least one processor, further cause the apparatus at least to: provide an input signal to the input of the DPD circuitry and to the input of the ST-DPD circuitry; and obtain a combined output signal based on a reciprocal of an output signal of the DPD circuitry and an output signal of the ST-DPD circuitry.

In an example embodiment of the first aspect, the ST-DPD circuitry further comprises an auxiliary input, and the instructions, when executed by the at least one processor, further cause the apparatus at least to: provide an input signal to the input of the DPD circuitry and to the input of the ST-DPD circuitry; provide an output signal of the DPD circuitry to the auxiliary input of the ST-DPD circuitry; and obtain a combined output signal.

In an example embodiment of the first aspect, the instructions, when executed by the at least one processor, further cause the apparatus at least to: obtain a feedback signal of the power amplifier output; align a time of an input signal and a time of the feedback signal, wherein the input signal is an input signal of a DPD model comprising at least the DPD circuitry; determine a gain based on the input signal and the feedback signal of the power amplifier; determine if a minimum linearity requirement for the determined gain is met; determine if the machine-learning model needs to be adapted based on if the minimum linearity requirement for the determined gain is met; obtain, from the machine-learning model, coefficients for the plurality of filters; and adapt the obtained coefficients to the DPD circuitry based on the determining if the machine-learning model needs to be adapted.

In an example embodiment of the first aspect, the instructions, when executed by the at least one processor, further cause the apparatus at least to: forward pass an input signal through an unfolded model of the DPD circuitry to obtain an output signal representing response of the power amplifier at each time step; determine an error signal based on computing a difference between a power amplifier output signal and the output signal; backpropagate the determined error signal through the unfolded model to determine coefficient gradients of the unfolded model; combine the obtained coefficient gradients; and adjust coefficients of the DPD circuitry based on the combined gradients.

According to a second aspect, a network node device is disclosed. The network node device may comprise the apparatus according to the first aspect.

According to a third aspect, a user equipment is disclosed. The user equipment may comprise the apparatus according to the first aspect.

According to a fourth aspect, a method is disclosed. The method may comprise: obtaining a feedback signal of a transmitter output, the transmitter comprising: at least a digital pre-distorter, DPD, circuitry comprising one or more first-order infinite impulse response, IIR, filters and one or more second-order IIR filters; and at least one power amplifier; aligning a time of an input signal and a time of the feedback signal, wherein the input signal is an input signal of a DPD model comprising at least the DPD circuitry; determining a gain based on the input signal and the feedback signal of the power amplifier; determining if a minimum linearity requirement for the determined gain is met; determining if the machine-learning model needs to be adapted based on if the minimum linearity requirement for the determined gain is met; obtaining, from the machine-learning model, coefficients for the plurality of filters; and adapting the obtained coefficients to the DPD circuitry based on the determining if the machine-learning model needs to be adapted.

An example embodiment of the fourth aspect may further comprise: forward passing at least a portion of the input signal through an unfolded model of the DPD circuitry to obtain an output signal representing response of the power amplifier at each time step; determining an error signal based on computing a difference between a power amplifier output signal and the output signal; backpropagating the determined error signal through the unfolded model to determine coefficient gradients of the unfolded model; combining the obtained coefficient gradients; and adjusting coefficients of the DPD circuitry based on the combined gradients.

According to a fifth aspect, a computer program is disclosed. The computer program comprising instructions causing an apparatus to perform the method according to the third aspect.

According to a sixth aspect, an apparatus is disclosed. The apparatus may comprise at least: a digital pre-distorter, DPD, circuitry, comprising a plurality of filters including at least one first-order infinite impulse response, IIR, filter and at least one second-order IIR filter; a power amplifier; and means for compensating for non-linearities in the power amplifier by using the at least one first-order IIR filter and the at least one second-order IIR filter.

An example embodiment of the sixth aspect may further comprise at least: means for applying the DPD circuitry in a machine-learning model to obtain coefficients of the plurality of filters.

An example embodiment of the sixth aspect may further comprise at least: means for determining an unfolded model of the DPD circuitry; and means for using backpropagation through time training technique on the unfolded model to obtain coefficients of the plurality of filters.

An example embodiment of the sixth aspect may further comprise at least: means for initiating coefficients of the plurality of filters with a noise value.

An example embodiment of the sixth aspect may further comprise at least: means for operating a baseband processing system; and means for operating the DPD circuitry at a lower sample rate, than an operation sample rate of the baseband processing system.

An example embodiment of the sixth aspect may further comprise at least: a short-term digital pre-distorter, ST-DPD, circuitry comprising an input and an output; the DPD circuitry further comprising an input and an output; and means for compensating for short-term non-linearities in the power amplifier by using the ST-DPD circuitry.

An example embodiment of the sixth aspect may further comprise at least: means for determining an intermediate result based an input signal and a reciprocal of an output signal provided by the output of the DPD circuitry; and provide the intermediate result to the input of the ST-DPD circuitry; and means for obtaining a combined output signal from the output of the ST-DPD circuitry based at least partially on the intermediate result.

An example embodiment of the sixth aspect may further comprise at least: means for providing an input signal to the input of the DPD circuitry and to the input of the ST-DPD circuitry; and means for obtaining a combined output signal based on a reciprocal of an output signal of the DPD circuitry and an output signal of the ST-DPD circuitry.

An example embodiment of the sixth aspect may further comprise at least: the ST-DPD circuitry further comprises an auxiliary input; and means for providing an input signal to the input of the DPD circuitry and to the input of the ST-DPD circuitry; means for providing an output signal of the DPD circuitry to the auxiliary input of the ST-DPD circuitry; and means for obtaining a combined output signal.

An example embodiment of the sixth aspect may further comprise at least: means for obtaining a feedback signal of the power amplifier output; means for aligning a time of an input signal and a time of the feedback signal, wherein the input signal is an input signal of a DPD model comprising at least the DPD circuitry; means for determining a gain based on the input signal and the feedback signal of the power amplifier; means for determining if a minimum linearity requirement for the determined gain is met; means for determining if the machine-learning model needs to be adapted based on if the minimum linearity requirement for the determined gain is met; means for obtaining, from the machine-learning model, coefficients for the plurality of filters; and means for adapting the obtained coefficients to the DPD circuitry based on the determining if the machine-learning model needs to be adapted.

An example embodiment of the sixth aspect may further comprise at least: means for forward passing an input signal through an unfolded model of the DPD circuitry to obtain an output signal representing response of the power amplifier at each time step; means for determining an error signal based on computing a difference between a power amplifier output signal and the output signal; means for backpropagating the determined error signal through the unfolded model to determine coefficient gradients of the unfolded model; means for combining the obtained coefficient gradients; and means for adjusting coefficients of the DPD circuitry based on the combined gradients.

## DESCRIPTION OF THE DRAWINGS

The accompanying drawings, which are included to provide a further understanding of the embodiments and constitute a part of this specification, illustrate embodiments and together with the description help to explain the principles of the embodiments. In the drawings:

**FIG. 1** illustrates a digital pre-distortion circuitry according to an example embodiment.
**FIG. 2** illustrates a transient response diagram of a power amplifier and different IIR filters.
**FIG. 3** illustrates a digital pre-distortion circuitry according to an example embodiment.
**FIG. 4** illustrates an unfolded model of the digital pre-distortion circuitry illustrated in Fig.'s 1 and 3, and how machine-learning can be applied to the unfolded model to obtain coefficients of the digital pre-distortion circuitry.
**FIG.'S 5A-C** illustrates block diagram of different configurations of the digital pre-distortion circuitry in operating in conjunction with a short-term digital pre-distortion circuitry.
**FIG. 6** illustrates a block diagram of a transmitter system according to an example embodiment.
**FIG. 7** illustrates a method according to an example embodiment.
**FIG. 8** illustrates a method according to an example embodiment.
**FIG. 9** illustrates an apparatus configured to practice example embodiments.
**FIG. 10** illustrates a network node device according to an example embodiment.
**FIG. 11** illustrates a user equipment according to an example embodiment.

Like reference numerals are used to designate like parts in the accompanying drawings.

## DETAILED DESCRIPTION

Reference will now be made in detail to embodiments, examples of which are illustrated in the accompanying drawings. The detailed description provided below in connection with the appended drawings is intended as a description of the present examples and is not intended to represent the only forms in which the present example may be constructed or utilized. The description sets forth the functions of the example and the sequence of steps for constructing and operating the example. However, the same or equivalent functions and sequences may be accomplished by different examples.

To achieve low error in a transmission and ensure compliance with the 3GPP spectral emission mask, particularly in base station applications, digital predistortion (PDP) is typically applied at baseband to mitigate distortions occurring in a radio frequency (RF) power amplifier (PA). DPD techniques for compensating PA non-linearities and short-term memory behavior during static transmission may comprise methods ranging from low-complexity Look-up-Table (LUT) -based schemes to more accurate Volterra-based models and even neural network (NN) based techniques. DPD models may typically operate in a per-sample mode to address memory effects in, for example, a 10-40 ns time window. By contrast, PA transient response has a much longer time span, ranging from, for example, 10 $\mu$s to 1 ms. Furthermore, the transient response cannot be capture by short-term dynamics of typical DPD models.

PA DPD solutions may comprise, for example, one or more first-order infinite impulse response (IIR) filters, wherein coefficients of the IIR filters are either tuned manually or extracted from physics -based consideration and specific lab measurements, which may prevent scenarios, where coefficients of the filter could be adapted during runtime.

To support latency-critical communications, and adaptive time division duplex (TDD) or mini-slot based scheduling in new radio (NR) applications, such as 5G, 6G or beyond, it is crucial to model and correct a transient response in a PA, such as a GaN PA. Therefore, a suitable model approximating transient response of the PA may comprise damped oscillatory behavior should be considered. Furthermore, manual tuning of filter coefficients is cumbersome and limited in accuracy.

It is at least one object of this disclosure to provide a solution, in which a DPD circuitry comprising a plurality of filters, wherein the plurality of filters comprises at least one first-order infinite impulse response (IIR) filter and at least one second-order IIR filter, is configured to compensate for non-linearities in a PA, particularly long-term idle-to-active state transient response of the PA. The at least one second-order IIR filter may be tuned for damped oscillator behavior. While the disclosure may generally refer to base station (network node) side applications, example embodiments may be applied in, for example, user equipment side as well.

Consequently, another objective of this applications may comprise a solution, where coefficients of the plurality of filters may be determined by a machine-learning model, particularly using backpropagation through time (BPTT) technique for training.

Furthermore, another objective of this applications may comprise one or more solutions, in which a short-term DPD (ST-DPD) model is applied in conjunction with the DPD circuitry disclosed herein.

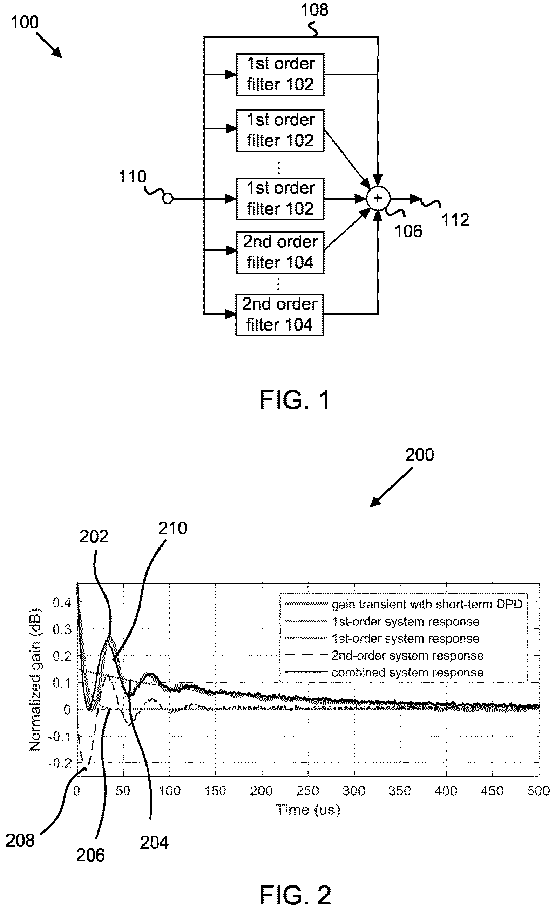

Fig. 1 illustrates a schematic of an example embodiment of a digital pre-distorter circuitry 100 (DPD Circuitry 100). The DPD circuitry 100 may comprise a plurality of filters, wherein the plurality of filters may comprise one or more first-order IIR filters 102 and one or more second-order IIR filters 104. It is noted that the DPD circuitry 100 may comprise any suitable configuration of filters, even a higher order IIR filter, such as a third-order IIR filter. The one or more first-order IIR filters 102 may be set with different coefficients modelling a decreasing transient response over time and the one or more second-order IIR filters 104 may be set with different coefficients for modelling a damped oscillator transient response.

The DPD circuitry 100 may further comprise a summation node 106, wherein outputs of each filter from the plurality of filters are summed. Furthermore, the DPD circuitry 100 may comprise an output and a bypass path 108, wherein a signal at an input 110 is summed with the outputs of each filter.

Fig. 2 illustrates a transient response diagram 200 of a PA transient response from an idle state to active state and transient response of different filters from the plurality of filters, wherein coefficients of the plurality of filters in the example illustrated in Fig. 2 are tuned manually (e.g., by hand). Y-axis shows time over 0-500 $\mu$s and X-axis shows normalized gain for each response. Graph 202 illustrates transient response of a PA with short-term DPD. Graph 204 illustrates transient response of a first first-order IIR filter 102, graph 206 illustrates transient response of a second first-order IIR filter 102 and graph 208 illustrates transient response of a first second-order IIR filter 104. Finally, graph 210 illustrates transient response of a combined system, wherein the DPD circuitry 100 is applied in conjunction with the short-term DPD.

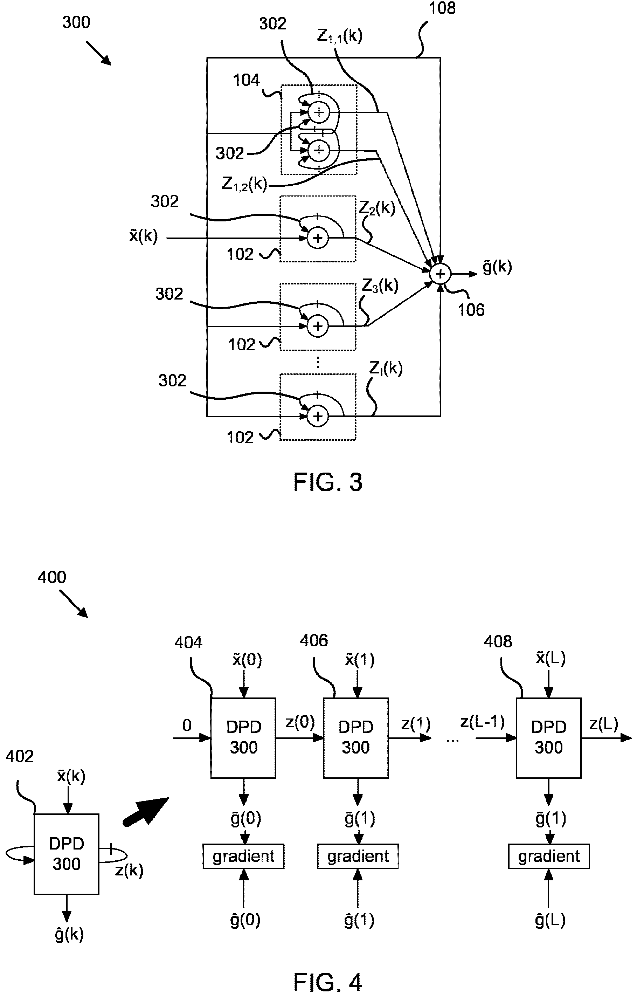

Fig. 3 illustrates a block diagram of an example embodiment of DPD circuitry 300, wherein feedback paths of each filter in the plurality of filters are illustrated and several mathematical symbols representing input, output and feedback. The example DPD circuitry 300 comprises a second-order IIR filter 104, and number I first-order IIR filters 102. The DPD circuitry 300 may comprise the DPD circuitry 100 of Fig. 1.

As a sampling rate of a baseband signal is generally high in relation to variations and a duration of long-term transient effects in a PA, respective poles of IIR filters operating at such high rate would be very close to one and sensitive to even small changes in coefficients, therefore, in some embodiments, input signal may be down-sampled with respect to an operation sample rate of, for example, a baseband processing unit the DPD circuitry 300 (or DPD circuitry 100) is configured to be operated in. In other words, an operation sample rate of the DPD circuitry 300 may be lower, than an operation sample rate of the baseband processing unit or the sampling rate of the baseband signal, therefore in this disclosure, a tilde (~) character may be added to denote down-sampled signals. When operating at a lower sample rate, the coefficient tuning may be more robust as the filter response is less sensitive to changes or coefficients.

The DPD circuitry 300 may be provided an input signal $\tilde{x}(k)$, and an output signal $\tilde{g}(k)$ may be obtained by summing outputs of each filter. In addition, bypass path 108 may comprise summing an unprocessed input signal $\tilde{x}(k)$ at the summing node 108. Outputs of each individual filter are denoted as $z_{i,j}(k)$, wherein i may denote an index of a filter, and j may denote one output path from an IIR filter of second-order or higher. Therefore, the output of the first-order IIR filters 102 do not have a j denotation. Feedback nodes 302 illustrate, how a delayed output $z_{i,j}(k)$ can be summed back to each filter in an unfolded model of the DPD circuitry 300.

Each of the IIR filters in the plurality of filters may be realized as a recurrent structure, similar to a recurrent neural network (RNN) without nonlinear activation or a gating mechanism. Each individual filter, as described above, may have an output as follows:

$$z_i(k) = \boldsymbol{a}_i\, x(k) + \boldsymbol{b}_i\, z_i(k-1), (1)$$

where $z_i \in \mathbb{R}^{N_i}$ is an output of a filter with index i with order $N_i$, $\boldsymbol{a}_i$ are feedforward coefficients of the filter with index i and $\boldsymbol{b}_i$ are the feedback coefficients of the filter with index i. Furthermore, $\boldsymbol{a}_i \in \mathbb{R}^{N_i \times 1}$ and $\boldsymbol{b}_i \in \mathbb{R}^{N_i \times N_i}$.

The outputs of each filter may be combined in a linear fashion to model PA gain $\tilde{g}(k)$ as follows:

$$\tilde{g}(k) = \tilde{x}(k) + \sum_{i=0}^{I} c_i z_i(k), (2)$$

where $\boldsymbol{c}_i \in \mathbb{R}^{N_i \times 1}$ and $N_0 = 1$ and $\tilde{x}(k)$ denotes the bypass path 108 path.

Fig. 4 illustrates a block diagram of an unfolded model 400 of the DPD circuitry, and at least a portion of an example of a machine-learning based training method, how coefficients of example embodiments of DPD circuitry 300 (or DPD circuitry 100) may be adjusted automatically. The block diagram 400 illustrates a backpropagation through time (BPTT) training method, wherein the DPD circuitry 300 is unfolded into a sequence-to-sequence model, according to a recurrent connection between each model.

At 402, The DPD circuitry 300 is illustrated as a recurrent structure, wherein the output $z_{i,j}(k)$ of each filter are fed back to the DPD circuitry 300 to their associated filters, e.g., $z_{1,2}(1)$ is fed to the lower input of a second order filter 104 of a third recurrent structure in the block diagram 400.

At 404, a zero is provided to the feedback summation of each associated filter to initiate the feedback nodes 302, and a first sample of an input signal $\tilde{x}(0)$ is provided to the input of the DPD circuitry 300, yielding a first sample of an output signal $\tilde{g}(0)$.

At 406, a set of first delayed outputs $z_i(0)$ is then provided to each feedback node (i,j) of each associated filter, and a second input sample of the input signal $\tilde{x}(1)$ is provided to the input of the DPD circuitry 300, yielding a second sample of the output signal $\tilde{g}(k)$.

This process may be performed, to the total number of L stages, where L may denote a length of the input signal $\tilde{x}(k)$, a length of a baseline training dataset $\hat{g}(k)$, or a number representing time of a full transient response of a PA, for example. The model may process a full sequence at a time, and gradient for the coefficients can be estimated across the unfolded model's 400 connections in the model. The DPD coefficients in this sequence are shared across the unfolded instances.

At 408, where a last sample of the input signal $\tilde{x}(L)$ is provided to the input of the unfolded model 400, and delayed output samples $z(L - 1)$ from the second last stage are provided to the feedback node of each associated filter.

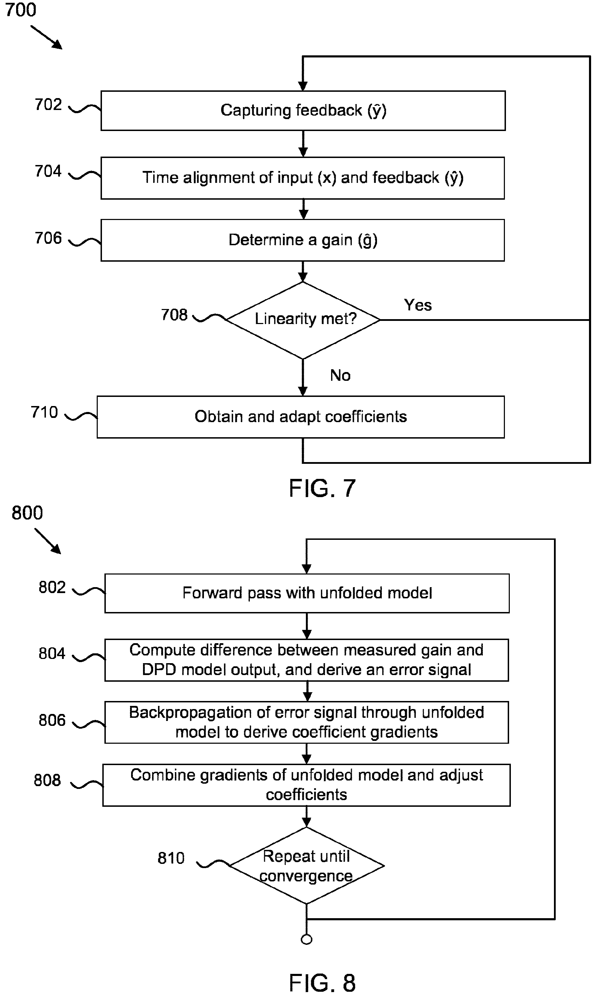

To tune coefficients of the unfolded model 400, data driven machine-learning may be applied. The coefficients may be initialized with parameters detailed more below, particularly in reference to Fig. 8, followed by iterative gradient adaptation with respect to the baseline training data set g(k). The down-sampling may be performed by, for example, taking a windowed average of the gain. Up-sampling may be performed by expansion or interpolation, e.g., replicating the filter output between the low-rate samples. The operation sample rate of the DPD circuitry 300 (or the unfolded model 400) may be, for example, 512 times lower than the operation sample rate of the baseband signal (e.g., original sample rate). Here, in reference to Fig. 4, another benefit of using down-sampling may be seen, as for a high sample rate, the number L of recurrent stages in the unfolded model 400 would be higher, than when operating in a lower sample rate, which would make machine-learning cumbersome, as the total number of filters in the unfolded model 400 would be very high.

With a random initialization of the filter coefficients, each second-order IIR filter may be initialized, for example, as follows:

$$\boldsymbol{a}^{(0)}_{2^{\text{nd}}\ \text{ord}} = \begin{pmatrix} \alpha \\ \alpha \end{pmatrix}, \qquad \boldsymbol{b}^{(0)}_{2^{\text{nd}}\ \text{ord}} = \begin{pmatrix} \beta & \gamma \\ -\gamma & \beta \end{pmatrix} + \mathcal{N}_0, (3)$$

wherein $\boldsymbol{a}^{(0)}_{2^{\text{nd}}\ \text{ord}}$ represents initial values of feedforward coefficients of the second-order IIR filter 104 and $\boldsymbol{b}^{(0)}_{2^{\text{nd}}\ \text{ord}}$ represents initial values of feedback coefficients of the second-order IIR filter 104, and wherein $\alpha$, $\beta$ and $\gamma$ are the initialization parameters, where $\alpha$ should be a value close or equal to one, for example, 0.9. $\beta$ can be chosen from range 0.5 < $\beta$ < 1 and $\gamma$ may be a value close or equal to zero for example, $|\gamma| < |\beta|$, 0 < $\gamma$ < 0.5 or -0.5 < $\gamma$ < 0. $\mathcal{N}_0$ is a random noise value to introduce a small variation in the coefficients.

Therefore, an example embodiment may comprise following initialization parameters for the second-order IIR filters 104:

$$a_{2^{\text{nd}} \text{ ord}}^{(0)} = \begin{pmatrix} 0 \\ 0 \end{pmatrix}, \qquad b_{2^{\text{nd}} \text{ ord}}^{(0)} = \begin{pmatrix} 0.9 & 0.1 \\ -0.1 & 0.9 \end{pmatrix} + \mathcal{N}_0. \, (4)$$

Consequently, initialization parameters for each first-order IIR filter 102 may be chosen as follows:

$$a_{1^{\text{st}} \text{ ord}}^{(0)} = \alpha, \qquad b_{1^{\text{st}} \text{ ord}}^{(0)} = \beta + \mathcal{N}_0, \, (5)$$

wherein $a_{1^{\text{st}} \text{ ord}}^{(0)}$ represents an initial value of a feedforward coefficient of the first-order IIR filter 102, $b_{1^{\text{st}} \text{ ord}}^{(0)}$ represents an initial value of a feedback coefficients of the first-order IIR filter 102. The rules for the initialization parameters $\alpha$, $\beta$ and $\gamma$ may follow the above-described rules for the second-order IIR filter 104 initialization values. E.g., an example embodiment may comprise following initialization parameters for the first-order IIR filters 102:

$$a_{1^{\text{st}} \text{ ord}}^{(0)} = 0, \qquad b_{1^{\text{st}} \text{ ord}}^{(0)} = 0.9 + \mathcal{N}_0. \, (6)$$

As discussed above, one of the objectives of the disclosure is to combine a short-term DPD (ST-DPD) with the DPD circuitry 100 (or DPD circuitry 300). Fig.'s 5A-C illustrate three different block diagram embodiments 500, 510 and 520, how the DPD circuitry 100 (or DPD circuitry 300) can work in conjunction with a ST-DPD 502. The ST-DPD 502 may comprise, for example, a neural network ST-DPD.

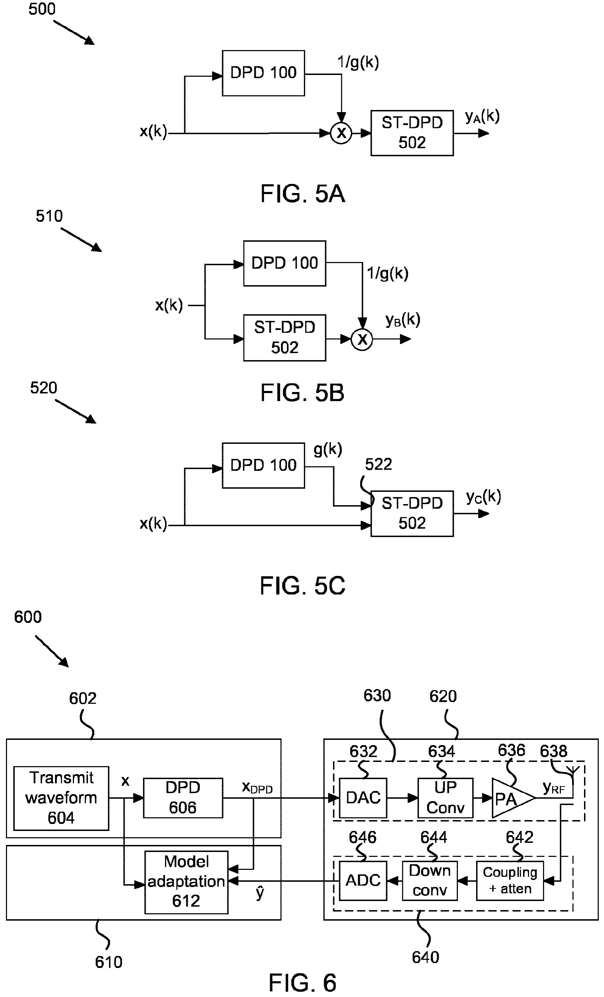

In Fig. 5A, gain correction is applied before a ST-DPD 502. A combined system response $y_A(k)$ would then comprise the following:

$$y_{\text{A}}(k) = f_{\text{DPD}}\left(\frac{x(k)}{g(k)}\right), \, (7)$$

wherein $f_{\text{DPD}}$ denotes the response of the ST-DPD.

In Fig. 5B, output of the ST-DPD 502 is multiplied with a reciprocal of the DPD circuity 100 output g(k), therefore, a combined system response $y_B(k)$ would then comprise the following:

$$y_{\text{B}}(k) = \frac{1}{g(k)} f_{\text{DPD}}\big(x(k)\big). \, (8)$$

In Fig. 5C, the ST-DPD 502 is augmented by providing the DPD circuitry output g(k) to an auxiliary input 522 of the ST-DPD 502 (i.e., the ST-DPD 502 comprises an auxiliary input). The ST-DPD 502 would then apply the gain correction in conjunction with a configured short-term DPD correction. Therefore, a combined system response $y_C(k)$ would then comprise the following:

$$y_{\text{C}} = f_{\text{DPD}}\big(x(k), g(k)\big). \, (9)$$

Fig. 6 illustrates a block diagram of a transmitter system 600 according to an example embodiment. The transmitter system 600 may comprise a baseband processing block 602, wherein the baseband processing block 602 may comprise a transmit waveform block 604 and an example embodiment of a DPD model 606. The DPD model 606 may comprise, for example, at least the DPD circuitry 100. In other embodiments, the DPD model 606 may comprise the DPD circuitry 100 and the ST-DPD 606 operating in conjunction as illustrated in Fig.'s 5A-C. The transmit waveform block 604 may be configured to prepare a transmit signal x (or in other words, a transmit waveform x as it may be referred to as in this description) for transmission, including operations like encoding, pre-processing etc. The DPD model 606 may then be configured to perform the down-sampling for the transmit signal $x$ and up-sampling the output to provide a pre-distorted signal $x_{DPD}$ as described above. As discussed above, down-sampling and up-sampling may not be required.

The transmitter system 600 may further comprise a DPD monitor and calibration block 610 comprising functionality for monitoring the operation of the DPD model 606 and functionality for adapting coefficients of the plurality

**EP 4 723 475 A1**

of filters in the DPD circuitry 100. The DPD monitor and calibration block may comprise a model adaptation block 612 configured to perform at least a portion of the monitoring and adaptation operations.

While the DPD monitor and calibration block 610 may be operated on a same device operating the baseband processing block, the DPD monitor and calibration block 610 may be comprised in a physically different device (e.g., online operation and calibration of the coefficients) than the baseband processing block 602. For example, if the baseband processing block 610 is comprised in a base station (e.g. network node), the DPD monitor and calibration block 610 can be operated on, for example, a cloud device.

The transmitter system 600 may further comprise an analog front-end 620, wherein the analog front-end 620 may comprise an analog transmitter block 630 and a feedback receiver 640. The analog transmitter block 630 may typically comprise a digital-to-analog converter 632 (DAC 632), an up-converter 634 (e.g., baseband to RF), a power amplifier 636 and one or more antennas 638. The feedback receiver 640 may comprise a coupling and attenuation block 642, a downconverter 644 (e.g., RF to baseband) and an analog-to-digital converter 646 (ADC 646).

The output $\hat{y}$ of the ADC 646 may then be provided to the model adaptation block 612 to monitor effects of the PA 636 to the pre-distorted signal $x_{DPD}$. The model adaptation block 612 may be further provided the transmit waveform signal x and the pre-distorted signal $x_{DPD}$.

Fig. 7 illustrates a flow diagram of a method 700 according to an example embodiment. The method 700 comprises operations, how the model adaptation block 612 may adapt coefficients determined by the machine-learning model illustrated in Fig. 4. The method 700 may be performed by an apparatus comprising, for example, at least one processor and at least one memory comprising instructions that cause the apparatus to perform the method 700. As an additional example, the model adaptation block 612 illustrated in Fig. 6 may be configured to perform the method 700.

At 702, the method 700 may comprise capturing a feedback signal ($\hat{y}$) of a power amplifier output (e.g., PA 636).

At 704, the method 700 may comprise aligning a time of an input signal (x) and a time of the feedback signal, wherein the input signal is an input signal of a digital pre-distortion model comprising at least the DPD circuitry 100 (e.g., DPD model 606). In other words, the input signal x may comprise a transmit waveform signal (e.g., the transmit waveform signal x in Fig. 6.).

At 706, the method 700 may comprise determining a gain between the input signal (x) and the feedback signal ($\hat{y}$). For example, the power amplifier gain may be determined based on:

$$\hat{g} = \mu \frac{\hat{y}^2}{x^2}, (8)$$

wherein $\mu$ is an optional scaling factor (for example, taking account the effects of the signal path from the DAC 632 to the ADC 646 excluding the PA 636), $\hat{y}$ is the feedback signal and x is the input signal.

At 708, the method 700 may comprise determining, if a gain linearity requirement of the determined gain at step 706 is met. For example, violation of max error threshold or mean-square error target. In other words, determining if the gain linearity requirement is met may comprise at least one of:

the gain linearity of the gain between the input signal and the feedback signal is above or below a threshold; or
the gain linearity of the gain between the input signal and the feedback signal is within a range.

At 710, the method 700 may comprise adapting transient model coefficients obtained from a machine-learning model configured to at least determine coefficients of the DPD circuitry 100, based on if the gain linearity requirement is met.

In other words, if the gain linearity is met (yes), the current coefficients of the DPD model 606 are determined to meet the linearity requirement, and the model adaptation block 612 may continue to monitor the feedback signal and go back to step 702 of the method 700. Otherwise, the coefficients of the machine-learning model should be adapted to the DPD model 606.

Fig. 8 illustrates a method 800 for training the DPD circuitry 100 (or DPD circuitry 300 as illustrated in Fig.'s 3-4). The method 800 comprises a backpropagation through time training technique. The method 800 can be performed by an apparatus comprising at least one processor and at least one memory comprising instructions causing the apparatus to perform the method 800. As an additional example, the model adaptation block 612 illustrated in Fig. 6 may be configured to perform the method 800.

At 802, the method 800 may comprise forward passing with an unfolded model of the DPD circuitry 100 (e.g., the unfolded model 400 in Fig. 4). The forward passing with an unfolded model may comprise, for example, providing an input signal ($\bar{x}(k)$) to an L number of recurrent models of the DPD circuitry 100, and providing each delayed sample ($z_{i,j}(k)$) to an associated filter in the plurality of filters of a recurrent model; and based on the providing the input signal and each delayed sample, obtaining an output signal ($\tilde{g}(k)$).

At 804, the method 800 may comprise, computing a difference between a measured gain of a transmitter chain comprising a power amplifier (e.g., PA 636) and between the obtained output signal ($\tilde{g}(k)$) to determine an error signal. The 'measured gain' here may refer to the gain determined at step 706 of the method 700.

At 806, the method 800 may comprise backpropagating the error signal determined at step 804 through the unfolded model to determine coefficient gradients of the unfolded model. In other words, first, the model output ($\tilde{g}(k)$) is derived while storing an intermediate result ($z(k)$) at each node of the unfolded model. This is followed by a computation of an error given an error metric, e.g., mean squared error, and further followed by computation of gradients for each model coefficient using a backpropagation rule.

At 808, the method 800 may comprise combining the obtained coefficient gradients of the unfolded model and adjusting the coefficients of the unfolded model based on the combined gradients. For example, the coefficients may be updated by applying the determined coefficient gradients using an update rule, e.g., applying stochastic gradient descent with momentum or adaptive moment optimizer.

In other words, 'combining the obtained coefficient gradients' may comprise the following: in the unfolded model 400, different gradients for the coefficients to be tuned are computed using the backpropagation rule. Since the coefficients are shared across several instances of the DPD circuitry 300 (of the unfolded structure), instead of adapting each instance of the DPD circuitry 300 individually, the computed gradients may be combined from the unfolded instances and tune the coefficients jointly by, for example, averaging the obtained coefficient gradients and tuning the coefficients using the averaged gradients.

At 810, the method 800 may comprise repeating the method 800 until convergence is reached. In other words, the convergence may be reached when, for example, an error threshold is met.

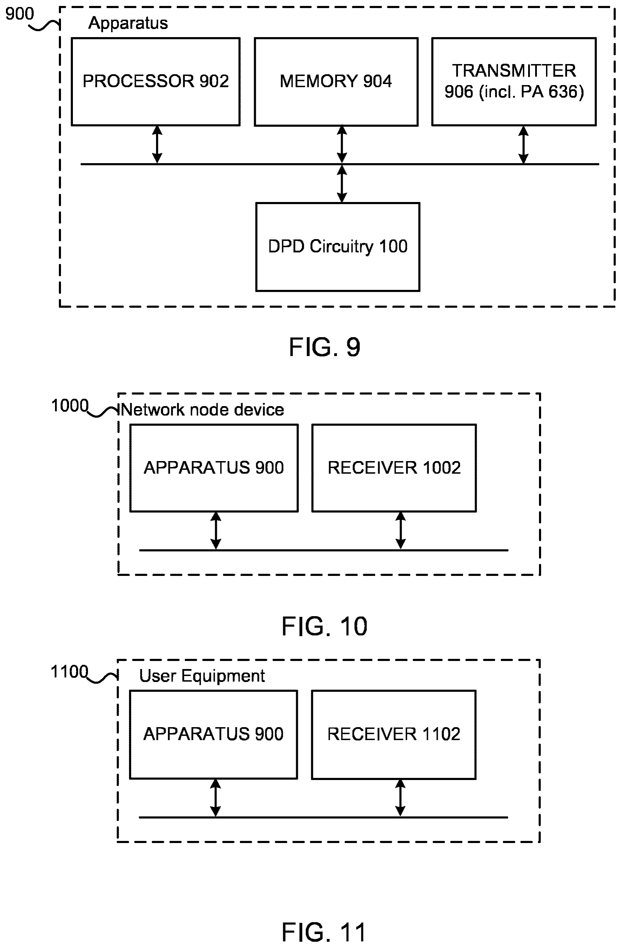

Fig. 9 illustrates a block diagram of an apparatus 900 configured to practice example embodiments discussed above. The apparatus 900 may comprise at least one processor 902 and at least one memory 904 comprising program code (in other words, program instructions).

The apparatus 900 may further comprise a transmitter 906, the transmitter 906 comprising at least a power amplifier (e.g., PA 636). One embodiment of the transmitter 906 may comprise the analog front-end 620 or portions thereof, as illustrated in Fig. 6, for example.

The apparatus 900, in one example, may comprise the baseband processing block comprising the DPD monitor and calibration block 610 illustrated in Fig. 6. In other words, the baseband processing block 602 and the DPD monitor and calibration block 610 can both be operated on the apparatus 900. In another example, the DPD monitor and calibration block 610 may be located on another device than the baseband processing block 602, and exchange of data can be performed by a communication interface not shown in Fig. 9.

The apparatus 900 may also include other elements, such as the communication interface (not shown in Fig. 9). The communication interface may be configured to enable the apparatus 900 to transmit and/or receive information to/from other devices, as well as other elements not shown in FIG. 9. In one example, the apparatus 900 may use the communication interface to transmit or receive signalling information and data in accordance with at least one cellular communication protocol. In another example, the communication interface may be configured to, for example, obtain configuration The communication interface may be configured to provide at least one wireless radio connection, such as for example a 3GPP mobile broadband connection (for example, 5G or 6G). The communication interface may comprise or be configured to be coupled to at least one antenna to transmit and/or receive radio frequency signals.

For example, the transmitter 906 and a receiver (not shown in Fig. 9) may comprise the communication interface.

Although the apparatus 900 is depicted to include only one processor 902, the UE apparatus 900 may include more than one processor. In an embodiment, the at least one memory 904 is capable of storing instructions, such as an operating system and/or various applications. Furthermore, the at least one memory 904 may include a storage that may be used to store, for example, at least some of the information and data used in the disclosed embodiments.

Furthermore, the at least one processor 902 is capable of executing the stored instructions. In an embodiment, the at least one processor 902 may be embodied as a multi-core processor, a single core processor, or a combination of one or more multi-core processors and one or more single core processors. For example, the at least one processor 902 may be embodied as one or more of various processing devices, such as a coprocessor, a microprocessor, a controller, a digital signal processor (DSP), a processing circuitry with or without an accompanying DSP, or various other processing devices including integrated circuits such as, for example, an application specific integrated circuit (ASIC), a field programmable gate array (FPGA), a microcontroller unit (MCU), a hardware accelerator, a special-purpose computer chip, a neural network (NN) chip, an artificial intelligence (AI) accelerator, a tensor processing unit (TPU), a neural processing unit (NPU), or the like. In an embodiment, the at least one processor 902 may be configured to execute hard-coded functionality. In an embodiment, the at least one processor 902 may be embodied as an executor of software instructions, wherein the instructions may specifically configure the at least one processor 902 to perform the algorithms and/or operations described herein when the instructions are executed.

The at least one memory 904 may be embodied as one or more volatile memory devices, one or more non-volatile memory devices, and/or a combination of one or more volatile memory devices and non-volatile memory devices. For example, the at least one memory 904 may be embodied as semiconductor memories (such as mask ROM, PROM (programmable ROM), EPROM (erasable PROM), flash ROM, RAM (random access memory), etc.).

In other words, the instructions, when executed by the at least one processor 902, may cause the apparatus 900 to operate, at least portions of the baseband processing block 602 illustrated in Fig. 6, such as the transmit waveform block 604 or the DPD model 606.

An example embodiment of the apparatus 900 may further comprise: the digital pre-distorter, DPD, circuity 100, comprising a plurality of filters including at least one first-order infinite impulse response, IIR, filter (e.g., first-order IIR filter 102) and at least one second-order IIR filter (e.g., second-order IIR filter 104); and the instructions which, when executed by the at least one processor 902, cause the apparatus 900 at least to: compensate for non-linearities in the power amplifier (e.g., PA 636) by using the at least one first-order IIR filter and the at least one second-order IIR filter.

In other words, referring to the above embodiment of the apparatus 900, the instructions stored in at least one memory 904 may further cause the apparatus 900 at least to: operate the digital pre-distorter, DPD, circuitry 100, wherein the DPD circuitry 100 comprises a plurality of filters, and wherein the plurality of filters comprises at least: one first-order infinite impulse response, IIR, filter; and one second-order IIR filter; and wherein the plurality of filters is configured to compensate for non-linearities in the power amplifier. In other words, the apparatus 900 may comprise the DPD circuitry 100 illustrated in Fig. 1.

"Compensating for non-linearities in the power amplifier" may comprise, for example, mitigating transient effects of the PA 636, particularly long-term effects and even more particularly, mitigating transient effects form an idle state transition to an active state.

Furthermore, while Fig. 9 depicts the DPD circuitry 100 to be a separate block in the apparatus 900, it can be understood that the at least one processor 902 and the at least one memory 904 combination comprises the DPD circuity 100, as the instructions, when executed by the at least one processor 902, may cause the apparatus 900 to comprise the DPD circuitry 100.

In another example embodiment of the apparatus 900, the DPD circuitry 100 is applied in a machine-learning model to obtain coefficients of the plurality of filters. In other words, the DPD circuitry 100 operated by the apparatus 900 may be unfolded, as illustrated in Fig. 4, and the coefficients may be obtained by performing the method 800. The machine-learning model may comprise backpropagation through time technique.

In another example embodiment of the apparatus 900, initiating coefficients of the plurality of filters comprises a noise value. In other words, the section described above, in reference to Eq.'s 3-6 may provide information to initiate the coefficients efficiently.

In another example embodiment of the apparatus 900, the DPD circuitry 100 operates at a lower sample rate, than an operation sample rate of a baseband processing system operated by the apparatus 900. In other words, the DPD circuitry 100 is configured to operate, for example, in a sample rate 512 times lower, than a transmit waveform signal (x in Fig. 6) of the baseband processing block 602.

In another example embodiment of the apparatus 900, the apparatus 900 may further comprise: a short-term digital pre-distorter, ST-DPD, circuitry (e.g., ST-DPD 502) comprising an input and an output; the DPD circuity 100 further comprises an input and an output; and wherein the instructions, when executed by the at least one processor 902, further cause the apparatus 900 at least to: compensate for short-term non-linearities in the power amplifier by using the ST-DPD circuitry.

In other words, in the above example embodiment of the apparatus 900, the instructions, when executed by the at least one processor 902, may further cause the apparatus 900 at least to: operate a short-term digital pre-distorter, ST-DPD, circuitry (e.g., ST-DPD 502), wherein the ST-DPD circuitry is configured to compensate for short-term non-linearities in the power amplifier; and wherein the DPD circuitry 100 further comprises an input and an output and the ST-DPD circuitry comprises an input and an output. In even other words, the apparatus 900 is further configured to operate DPD model 606 illustrated in Fig. 6.

In an example embodiment of the apparatus 900, the instructions, when executed by the at least one processor 902, may further cause the apparatus at least to: determine an intermediate result based an input signal and a reciprocal of an output signal provided by the output of the DPD circuitry 100; provide the intermediate result to the input of the ST-DPD circuitry; and obtain a combined output signal (e.g., $y_A(k)$) from the output of the ST-DPD circuitry based at least partially on the intermediate result. This embodiment relates to Fig. 5A, and the ST-DPD circuitry 100 comprises the ST-DPD circuitry 502 illustrated in Fig.'s 5A-C. The intermediate result may be determined, for example, based on multiplying the input signal with the reciprocal of the output signal.

When referring to the combined output signal, it may be understood that the combination is based on using the DPD circuity 100 and the ST-DPD circuitry.

In an example embodiment of the apparatus 900, the instructions, when executed by the at least one processor 902, further cause the apparatus at least to: provide an input signal to the input of the DPD circuitry 100 and to the input of the ST-DPD circuitry; and obtain a combined output signal (e.g., $y_B(k)$) based on a reciprocal of an output signal of the DPD circuitry and an output signal of the ST-DPD circuitry. The combine output signal may be obtained by, for example, multiplying the reciprocal of the output signal of the DPD circuitry 100 and the output signal of the ST-DPD circuitry. This embodiment relates to Fig. 5B.

In an example embodiment of the apparatus 900, the ST-DPD circuitry further comprises an auxiliary input, and the instructions, when executed by the at least one processor 902, further cause the apparatus 900 at least to: provide an input signal to the input of the DPD circuitry 100 and to the input of the ST-DPD circuitry; provide an output signal of the DPD circuitry to the auxiliary input of the ST-DPD circuitry; and obtain a combined output signal $((y_C(k))$. This embodiment relates to Fig. 5C.

In another example embodiment of the apparatus 900, the instructions, when executed by the at least one processor 902, further cause the apparatus 900 at least to:

obtain a feedback signal of the power amplifier output;
align a time of an input signal and a time of the feedback signal, wherein the input signal is an input signal of a DPD model comprising at least the DPD circuitry 100 (e.g., the DPD model 606);
determine a gain based on the input signal and the feedback signal of the power amplifier;
determine if a minimum linearity requirement for the determined gain is met;
determine if the machine-learning model needs to be adapted based on if the minimum linearity requirement for the determined gain is met;
obtain, from the machine-learning model, coefficients for the plurality of filters; and
adapt the obtained coefficients to the DPD circuitry based on the determining if the machine-learning model needs to be adapted. This example embodiment refers to the method 700 in Fig. 7, where the apparatus 900 may be configured to, for example, perform the method 700.

The gain may be determined, based on, for example, between the transmitter input signal (e.g., the transmit waveform signal x) and the feedback signal (e.g., $\hat{y}$) of the power amplifier.

In another example embodiment of the apparatus 900, the instructions, when executed by the at least one processor 902, further cause the apparatus 900 at least to:

forward pass an input signal (e.g., $\tilde{x}(k)$) through an unfolded model (e.g., the unfolded model 400) of the DPD circuitry to obtain an output signal (e.g., $\tilde{g}(k)$) representing response of the power amplifier at each time step;
determine an error signal based on computing a difference between a power amplifier output signal and the output signal (e.g., $\tilde{g}(k)$);
backpropagate the determined error signal through the unfolded model to determine coefficient gradients of the unfolded model;
combine the obtained coefficient gradients; and
adjust coefficients of the DPD circuitry based on the combined gradients. This above embodiment refers to the method 800 illustrated in Fig. 8, wherein the apparatus 900 is further configured to perform the method 800.

Fig. 10 illustrates a block diagram of network node device 1000 configured to practice example embodiments.

The network node device 1000 may comprise the apparatus 900 illustrated in Fig. 9. The network node device 1000 may further comprise a receiver 1002. The receiver 1002 may further comprise, for example, a receiver configured to receive information according to one or more communication protocols, such as 4G, 5G, 6G or beyond. The receiver 1002 and the transmitter 906 combination may be comprised in a transceiver (not shown in Fig. 10) configured to transmit or receive signalling information and data in accordance with at least one cellular communication protocol.

In other words, the network node device may comprise at least one processor and at least one memory storing instructions which, when executed by the at least one processor, cause the network node device 1000 to practice example embodiments described herein.

The network node device 1000 may comprise a base station, a transmission reception point (TRP), a relay node and/or a satellite. In an example embodiment, the network node 1000 may be comprised in a satellite, such as a LEO satellite. The base station may include, for example, a 5G or 6G base station (gNB) or any such device providing an air interface for a user equipment to connect to a wireless network via wireless transmissions.

In other words, the network node device 1000 may comprise any aspects of the functionality described in reference to Fig.'s 1-9, such as the DPD circuitry 100, the DPD model 606 and/or the transmitter system 600. The network node device 1000 may be configured to perform, for example, the method 700 or the method 800, when instructions stored in the at least one memory 904 cause the network node device 100 to perform any aspects of the method 700 and/or the method 800.

The short-term DPD 502 (or a ST-DPD comprised in the DPD model 606) may comprise, for example, a neural network DPD such as phase normalized time-delay neural network however, the DPD circuitry 100 and the machine-learning model configured to determine coefficients of the DPD circuitry 100 is not limited to an application with a neural network DPD, and the neural network DPD is only given as one example.

Fig. 11 illustrates an example embodiment of a user equipment 1100 configured to practice example embodiment. The user equipment 1100 may comprise any example embodiment of the apparatus 900 described herein, and a receiver 1102.

The user equipment 1100 may comprise a cell phone, a tablet, a smart watch, an Internet-of-Things (IoT) device, etc. As an example, the receiver 1102 and the transmitter 906 combination may be comprised in a transceiver (not shown in Fig. 10) configured to transmit or receive signalling information and data in accordance with at least one cellular communication protocol.

One method to validate the performance of the embodiments described herein may comprise, for example, using a 5G compliant test carrier with an instantaneous bandwidth of 100 MHz. The test waveform may be operated in TDD mode, where alternating slots may be allocated to UL/DL. A sub-carrier spacing may be, for example, 60 kHz, where each OFDM slot may comprise 14 OFDM symbols. The PA may comprise, for example, a GaN Doherty PA module, or the like, wherein the PA may operate in a C-band with 3.6 GHz center frequency, for example. Error vector magnitude (EVM) may be used as a metric to measure performance, for example.

Another example of an apparatus suitable for carrying out the embodiments and examples of the apparatus 900 disclosed herein, and with regards to Fig.'s 1 - 8 may comprise at least: a digital pre-distorter, DPD, circuitry, comprising a plurality of filters including at least one first-order infinite impulse response, IIR, filter (102) and at least one second-order IIR filter (104); a power amplifier (e.g., PA 636); and means for compensating for non-linearities in the power amplifier by using the at least one first-order IIR filter and the at least one second-order IIR filter.

Another example of an apparatus suitable for carrying out the embodiments and examples of the apparatus 900 may comprise at least: means for applying the DPD circuitry in a machine-learning model to obtain coefficients of the plurality of filters.

Another example of an apparatus suitable for carrying out the embodiments and examples of the apparatus 900 may comprise at least: means for determining an unfolded model of the DPD circuitry; and means for using backpropagation through time training technique on the unfolded model to obtain coefficients of the plurality of filters.

Another example of an apparatus suitable for carrying out the embodiments and examples of the apparatus 900 may comprise at least: means for initiating coefficients of the plurality of filters with a noise value.

Another example of an apparatus suitable for carrying out the embodiments and examples of the apparatus 900 may comprise at least: means for operating a baseband processing system; and means for operating the DPD circuitry at a lower sample rate, than an operation sample rate of the baseband processing system.

Another example of an apparatus suitable for carrying out the embodiments and examples of the apparatus 900 may further comprise at least: a short-term digital pre-distorter, ST-DPD, circuitry comprising an input and an output; the DPD circuity further comprising an input and an output; and means for compensating for short-term non-linearities in the power amplifier by using the ST-DPD circuitry.

Another example of an apparatus suitable for carrying out the embodiments and examples of the apparatus 900 may comprise at least: means for determining an intermediate result based an input signal and a reciprocal of an output signal provided by the output of the DPD circuitry; and provide the intermediate result to the input of the ST-DPD circuitry; and means for obtaining a combined output signal from the output of the ST-DPD circuitry based at least partially on the intermediate result.

Another example of an apparatus suitable for carrying out the embodiments and examples of the apparatus 900 may comprise at least: means for providing an input signal to the input of the DPD circuitry and to the input of the ST-DPD circuitry; and means for obtaining a combined output signal based on a reciprocal of an output signal of the DPD circuitry and an output signal of the ST-DPD circuitry.

Another example of an apparatus suitable for carrying out the embodiments and examples of the apparatus 900 may comprise at least: the ST-DPD circuitry further comprises an auxiliary input; and means for providing an input signal to the input of the DPD circuitry and to the input of the ST-DPD circuitry; means for providing an output signal of the DPD circuitry to the auxiliary input of the ST-DPD circuitry; and means for obtaining a combined output signal.

Another example of an apparatus suitable for carrying out the embodiments and examples of the apparatus 900 may comprise at least:

means for obtaining a feedback signal of the power amplifier output;
means for aligning a time of an input signal and a time of the feedback signal, wherein the input signal is an input signal of a DPD model comprising at least the DPD circuitry;
means for determining a gain based on the input signal and the feedback signal of the power amplifier;
means for determining if a minimum linearity requirement for the determined gain is met;
means for determining if the machine-learning model needs to be adapted based on if the minimum linearity requirement for the determined gain is met;
means for obtaining, from the machine-learning model, coefficients for the plurality of filters; and

means for adapting the obtained coefficients to the DPD circuitry based on the determining if the machine-learning model needs to be adapted.

Another example of an apparatus suitable for carrying out the embodiments and examples of the apparatus 900 may comprise at least:

means for forward passing an input signal through an unfolded model of the DPD circuitry to obtain an output signal representing response of the power amplifier at each time step;

means for determining an error signal based on computing a difference between a power amplifier output signal and the output signal;

means for backpropagating the determined error signal through the unfolded model to determine coefficient gradients of the unfolded model;

means for combining the obtained coefficient gradients; and

means for adjusting coefficients of the DPD circuitry based on the combined gradients.

'Means' may comprise, for example, a combination of at least one processor and at least one memory storing instructions, which cause the apparatus to, for example, perform operations referred herein.

One or more of the example and example embodiments discussed above may enable a solution which enables a DPD circuitry to improve transient response of a power amplifier, particularly form an idle state to active state (UL/DL).

Further, one or more of the example and example embodiments discussed above may enable a solution which enables machine-learning based adjusting of coefficients of filters comprised in the DPD circuitry.

Further, one or more of the example and example embodiments discussed above may enable a solution which enables online adaptation of the filter coefficients to account.

Further, one or more of the example and example embodiments discussed above may enable a solution that enables using a short-term DPD circuitry in conjunction with the DPD circuitry, to further improve the transient response.

At least a portion of the functionality described herein can be performed, at least in part, by one or more computer program product components such as software components. According to an embodiment, the apparatus 900 may comprise a processor or processor circuitry, such as for example a microcontroller, configured by the program code when executed to execute the embodiments of the operations and functionality described. Alternatively, or in addition, the functionality described herein can be performed, at least in part, by one or more hardware logic components. For example, and without limitation, illustrative types of hardware logic components that can be used include Field-programmable Gate Arrays (FPGAs), Application-specific Integrated Circuits (ASICs), Application-specific Standard Products (ASSPs), System-on-a-chip systems (SOCs), Complex Programmable Logic Devices (CPLDs), Tensor Processing Units (TPUs), and Graphics Processing Units (GPUs).

Any range or device value given herein may be extended or altered without losing the effect sought. Also, any embodiment may be combined with another embodiment unless explicitly disallowed.

An example embodiment of a computer program may comprise instructions causing an apparatus to perform the method 700 and/or the method 800.

Although the subject matter has been described in language specific to structural features and/or acts, it is to be understood that the subject matter defined in the appended claims is not necessarily limited to the specific features or acts described above. Rather, the specific features and acts described above are disclosed as examples of implementing the claims and other equivalent features and acts are intended to be within the scope of the claims.

It will be understood that the benefits and advantages described above may relate to one embodiment or may relate to several embodiments. The embodiments are not limited to those that solve any or all of the stated problems or those that have any or all of the stated benefits and advantages. It will further be understood that reference to 'an' item may refer to one or more of those items.

The steps of the methods described herein may be carried out in any suitable order, or simultaneously where appropriate. Additionally, individual blocks may be deleted from any of the methods without departing from the spirit and scope of the subject matter described herein. Aspects of any of the embodiments described above may be combined with aspects of any of the other embodiments described to form further embodiments without losing the effect sought.

The term 'comprising' is used herein to mean including the method, blocks or elements identified, but that such blocks or elements do not comprise an exclusive list and a method or apparatus may contain additional blocks or elements.

It will be understood that the above description is given by way of example only and that various modifications may be made by those skilled in the art. The above specification, examples and data provide a complete description of the structure and use of exemplary embodiments. Although various embodiments have been described above with a certain degree of particularity, or with reference to one or more individual embodiments, those skilled in the art could make numerous alterations to the disclosed embodiments without departing from the spirit or scope of this specification.

Claims

1. An apparatus (900) comprising:

   a digital pre-distorter, DPD, circuity (100), comprising a plurality of filters including at least one first-order infinite impulse response, IIR, filter (102) and at least one second-order IIR filter (104);
   a power amplifier (636);
   at least one processor (902); and
   at least one memory (904) comprising instructions which, when executed by the at least one processor, cause the apparatus at least to:
   compensate for non-linearities in the power amplifier by using the at least one first-order IIR filter and the at least one second-order IIR filter.

2. The apparatus (900) according to claim 1, wherein the DPD circuitry (100) is applied in a machine-learning model to obtain coefficients of the plurality of filters.

3. The apparatus (900) according to claim 2, wherein the machine-learning model comprises a backpropagation through time, BPTT, training technique.

4. The apparatus (900) according to any preceding claim, wherein initiating coefficients of the plurality of filters comprises a noise value.

5. The apparatus (900) according to any of claims 1-4, wherein the DPD circuitry (100) operates at a lower sample rate, than an operation sample rate of a baseband processing system (602) operated by the apparatus.

6. The apparatus (900) according to any preceding claim, wherein the apparatus further comprises:

   a short-term digital pre-distorter, ST-DPD, circuitry (502) comprising an input and an output;
   the DPD circuity (100) further comprises an input and an output; and
   wherein the instructions, when executed by the at least one processor (902), further cause the apparatus at least to:
   compensate for short-term non-linearities in the power amplifier (636) by using the ST-DPD circuitry.

7. The apparatus (900) according to claim 6, wherein the instructions, when executed by the at least one processor (902), further cause the apparatus at least to:

   determine an intermediate result based an input signal and a reciprocal of an output signal provided by the output of the DPD circuitry (100); and
   provide the intermediate result to the input of the ST-DPD circuitry (502); and
   obtain a combined output signal ($y_A(k)$) from the output of the ST-DPD circuitry based at least partially on the intermediate result.

8. The apparatus (900) according to claim 6, wherein the instructions, when executed by the at least one processor (902), further cause the apparatus at least to:

   provide an input signal to the input of the DPD circuitry (100) and to the input of the ST-DPD circuitry (502); and
   obtain a combined output signal ($y_B(k)$) based on a reciprocal of an output signal of the DPD circuitry and an output signal of the ST-DPD circuitry.

9. The apparatus (900) according to claim 6, wherein the ST-DPD circuitry (502) further comprises an auxiliary input (522), and the instructions, when executed by the at least one processor (902), further cause the apparatus at least to:

   provide an input signal to the input of the DPD circuitry (100) and to the input of the ST-DPD circuitry;
   provide an output signal of the DPD circuitry to the auxiliary input of the ST-DPD circuitry; and
   obtain a combined output signal (($y_C(k)$).

10. The apparatus (900) according to any of claims 2-9, wherein the instructions, when executed by the at least one processor (902), further cause the apparatus at least to:

**EP 4 723 475 A1**

obtain (702) a feedback signal of the power amplifier (636) output;

align (704) a time of an input signal and a time of the feedback signal, wherein the input signal is an input signal of a DPD model (606) comprising at least the DPD circuitry (100);

determine (706) a gain based on the input signal and the feedback signal of the power amplifier;

determine (708) if a minimum linearity requirement for the determined gain is met;

determine (708) if the machine-learning model needs to be adapted based on if the minimum linearity requirement for the determined gain is met;

obtain (710), from the machine-learning model, coefficients for the plurality of filters; and

adapt (710) the obtained coefficients to the DPD circuitry (100) based on the determining if the machine-learning model needs to be adapted.

11. The apparatus (900) according to claim 10, wherein the instructions, when executed by the at least one processor (902), further cause the apparatus at least to:

forward pass (802) an input signal ($\tilde{x}(k)$) through an unfolded model (400) of the DPD circuitry (100) to obtain an output signal ($\tilde{g}(k)$) representing response of the power amplifier (636) at each time step;

determine (804) an error signal based on computing a difference between a power amplifier output signal and the output signal ($\tilde{g}(k)$);

backpropagate (806) the determined error signal through the unfolded model to determine coefficient gradients of the unfolded model;

combine (808) the obtained coefficient gradients; and

adjust (808) coefficients of the DPD circuitry based on the combined gradients.

12. A network node device (1000), comprising the apparatus (900) according to any of claims 1-11.

13. A user equipment (1100), comprising the apparatus (900) according to any of claims 1-11.

14. A method (700), comprising:
obtaining (702) a feedback signal ($\hat{y}$) of a transmitter (600) output, the transmitter comprising:

at least a digital pre-distorter, DPD, circuitry (100) comprising one or more first-order infinite impulse response, IIR, filters (102) and one or more second-order IIR filters (104); and

at least one power amplifier (636);

aligning (704) a time of an input signal and a time of the feedback signal, wherein the input signal is an input signal of a DPD model (606) comprising at least the DPD circuitry;

determining (706) a gain based on the input signal and the feedback signal of the power amplifier;

determining (708) if a minimum linearity requirement for the determined gain is met;

determining (708) if the machine-learning model needs to be adapted based on if the minimum linearity requirement for the determined gain is met;

obtaining (710), from the machine-learning model, coefficients for the plurality of filters; and

adapting (710) the obtained coefficients to the DPD circuitry based on the determining if the machine-learning model needs to be adapted.

15. A computer program comprising instructions causing an apparatus to perform the method (700) of claim 14.

FIG. 1

FIG. 2

FIG. 3

FIG. 4

FIG. 5A

FIG. 5B

FIG. 5C

FIG. 6

700

| 702 | Capturing feedback (ŷ) |
| 704 | Time alignment of input (x) and feedback (ŷ) |
| 706 | Determine a gain (ĝ) |

708 — Linearity met? —— Yes

No

| 710 | Obtain and adapt coefficients |

## FIG. 7

800

| 802 | Forward pass with unfolded model |
| 804 | Compute difference between measured gain and DPD model output, and derive an error signal |
| 806 | Backpropagation of error signal through unfolded model to derive coefficient gradients |
| 808 | Combine gradients of unfolded model and adjust coefficients |

810 — Repeat until convergence

## FIG. 8

900

Apparatus

| PROCESSOR 902 | MEMORY 904 | TRANSMITTER 906 (incl. PA 636) |

DPD Circuitry 100

FIG. 9

1000 Network node device

| APPARATUS 900 | RECEIVER 1002 |

FIG. 10

1100 User Equipment

| APPARATUS 900 | RECEIVER 1102 |

FIG. 11

Europäisches
Patentamt
European
Patent Office
Office européen
des brevets

# EUROPEAN SEARCH REPORT

**Application Number**

EP 25 20 4516

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y<br>A | US 9 866 269 B1 (ZHAO HONGZHI [US] ET AL)<br>9 January 2018 (2018-01-09)<br>* column 7, line 23 - column 18, line 46;<br>figures 2-4B * | 1-6,8,<br>12,13<br>7,9-11,<br>14,15 | INV.<br>H03F1/32<br>H03F3/189<br>H03F3/24 |
| Y<br>A | US 2020/295850 A1 (SCHAEFER ANDREW [DE] ET AL) 17 September 2020 (2020-09-17)<br>* paragraphs [0014] - [0017], [0026], [0036] - [0039] *<br>* paragraph [0055] - paragraph [0067]; figures 1-5B *<br>* paragraph [0070] - paragraph [0076]; figure 8 * | 1-6,8,<br>12,13<br>7,9-11,<br>14,15 | |
| A | US 2023/370023 A1 (YU TAO [US] ET AL)<br>16 November 2023 (2023-11-16)<br>* paragraph [0024] - paragraph [0059]; figures 1A-1C *<br>* paragraph [0073] - paragraph [0086]; figures 4,5 *<br>* paragraph [0101] - paragraph [0110]; figure 10 * | 1-15 | |
| A | US 2023/111606 A1 (HE ZIMING [GB] ET AL)<br>13 April 2023 (2023-04-13)<br>* paragraph [0018] - paragraph [0022] *<br>* paragraph [0023] - paragraph [0100]; figures 1-7 * | 1-15 | |

TECHNICAL FIELDS
SEARCHED    (IPC)

H03F

The present search report has been drawn up for all claims

| Place of search | Date of completion of the search | Examiner |
|---|---|---|
| The Hague | 19 February 2026 | Wienema, David |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

This annex lists the patent family members relating to the patent documents cited in the above-mentioned European search report.
The members are as contained in the European Patent Office EDP file on
The European Patent Office is in no way liable for these particulars which are merely given for the purpose of information.

19-02-2026

| Patent document cited in search report | | Publication date | Patent family member(s) | | Publication date |
|---|---|---|---|---|---|
| US 9866269 | B1 | 09-01-2018 | CN | 109983693 A | 05-07-2019 |
| | | | EP | 3542460 A1 | 25-09-2019 |
| | | | JP | 7541437 B2 | 28-08-2024 |
| | | | JP | 2020504926 A | 13-02-2020 |
| | | | KR | 20190085050 A | 17-07-2019 |
| | | | US | 9866269 B1 | 09-01-2018 |
| | | | WO | 2018093910 A1 | 24-05-2018 |
| US 2020295850 | A1 | 17-09-2020 | NONE | | |
| US 2023370023 | A1 | 16-11-2023 | EP | 4277127 A1 | 15-11-2023 |
| | | | US | 2023370023 A1 | 16-11-2023 |
| US 2023111606 | A1 | 13-04-2023 | KR | 20230052240 A | 19-04-2023 |
| | | | US | 2023111606 A1 | 13-04-2023 |

EPO FORM P0459

For more details about this annex : see Official Journal of the European Patent Office, No. 12/82